(19) Europäisches Patentamt / European Patent Office / Office européen des brevets

(11) **EP 4 770 313 A1**

(12) **DEMANDE DE BREVET EUROPEEN**

(43) Date de publication:
**01.07.2026 Bulletin 2026/27**

(21) Numéro de dépôt: **25226587.1**

(22) Date de dépôt: **22.12.2025**

(51) Classification Internationale des Brevets (IPC):
**H10B 63/00** (2023.01) **H10N 70/00** (2023.01)
**H10N 70/20** (2023.01)

(52) Classification Coopérative des Brevets (CPC):
**H10N 70/20; H10B 63/84; H10B 63/845;**
**H10N 70/821; H10N 70/823; H10N 70/826;**
**H10N 70/841; H10N 70/8828**

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**
Etats d'extension désignés:
**BA**
Etats de validation désignés:
**GE KH LA MA MD TN**

(30) Priorité: **26.12.2024 FR 2415283**

(71) Demandeurs:
• **Commissariat à l'Energie Atomique et aux Energies Alternatives**
**75015 Paris (FR)**
• **Centre National de la Recherche Scientifique**
**75016 Paris (FR)**
• **Université Grenoble Alpes**
**38400 Saint-Martin-d'Hères (FR)**
• **Institut Polytechnique de Grenoble**
**38000 Grenoble (FR)**

(72) Inventeurs:
• **CULOT, Maxime**
**38054 GRENOBLE CEDEX 09 (FR)**
• **FROTTIER, Théo**
**38054 GRENOBLE CEDEX 09 (FR)**
• **SAVERO-TORRES, Williams**
**38054 GRENOBLE CEDEX 09 (FR)**
• **KANDAZOGLOU, Aurélie**
**38054 GRENOBLE CEDEX 09 (FR)**
• **TERESI, Salvatore**
**38054 GRENOBLE CEDEX 09 (FR)**
• **SGARRO, Pablo**
**38054 GRENOBLE CEDEX 09 (FR)**
• **BIBES, Manuel**
**38054 GRENOBLE CEDEX 09 (FR)**
• **VILA, Laurent**
**38054 GRENOBLE CEDEX 09 (FR)**
• **ATTANE, Jean-Philippe**
**38054 GRENOBLE CEDEX 09 (FR)**

(74) Mandataire: **Cabinet Camus Lebkiri**
**25 rue de Maubeuge**
**75009 Paris (FR)**

(54) **MÉMOIRES NON-VOLATILES À RÉSISTANCE VARIABLE, PROCÉDÉS ET ASSEMBLAGES ASSOCIÉS**

(57) L'invention concerne une mémoire (100) comprenant :
- une électrode conductrice principale (120) formant une cathode ;
- une électrode conductrice secondaire (130) formant une anode ; et
- une couche ferroélectrique semiconductrice (110) formant une couche active, disposée entre la cathode et l'anode (120, 130), la couche active (110) présentant une polarisation ferroélectrique (111) présentant une pluralité d'états stables,

la cathode (120) formant un contact principal avec la couche active (110), la résistance du contact principal variant de façon strictement monotone en fonction de la polarisation ferroélectrique (111), le comportement du contact principal formant, en fonction de la polarisation ferroélectrique (111) :
- un contact ohmique pour un premier état stable de la pluralité d'états stables ; et
- un contact Schottky pour au moins un deuxième état stable de la pluralité d'états stables,

la couche active (110) étant dégénérée et présentant une bande d'énergie interdite inférieure à 1,5 eV.

[Fig. 1]

Fig. 1

**Description**

**DOMAINE TECHNIQUE DE L'INVENTION**

Le domaine technique de l'invention est celui des mémoires non-volatiles à résistance variable. Le domaine technique concerne également les procédés de lecture et de fabrication de telles mémoires, ainsi que l'assemblage de telles mémoires sous forme de porte logique et de matrice.

**ARRIÈRE-PLAN TECHNOLOGIQUE DE L'INVENTION**

Des mémoires à résistance variable, dites « memristors », sont capables de stocker une information à au moins deux niveaux. Dans certains cas, ces memristors sont également en mesure de stocker une information pouvant présenter des niveaux intermédiaires et/ou réaliser des opérations logiques. Ce dernier type de mémoire présente un intérêt particulier dans l'implémentation de nouveaux paradigmes de calcul, tels que le calcul analogique ou le calcul neuromorphique.

Les memristors regroupent plusieurs familles de mémoires parmi lesquels on compte : les mémoires magnétiques et les mémoires résistives. Les mémoires magnétiques permettent de stocker une information dans une orientation relative de moments magnétiques. Les mémoires résistives permettent de stocker une information dans la résistance même d'une des couches qui les composent. Le changement de résistance de la couche est par exemple induit par un claquage contrôlé de la couche ou un changement de phase du matériau qui la compose.

Parmi les qualités des memristors, il est attendu qu'un memristor présente une variation de résistance, dite « rapport on/off », suffisamment élevée pour être mesurée facilement et rapidement, par exemple supérieur à $10^2$, et que ce rapport on/off puisse être mesuré même avec une faible tension de lecture. Il est également attendu qu'un memristor présente une endurance élevée, supérieure à $10^7$ cycles.

Les mémoires magnétiques les plus courantes comprennent des jonctions tunnel magnétiques (dites « MTJ » pour « Magnetic Tunnel Junction » en anglais). Les MTJ présentent généralement une bonne endurance. En revanche elles montrent un rapport on/off faible, par exemple de quelques unités.

Les mémoires résistives pour lesquelles l'une des couches subit un changement de phase ou un claquage électrostatique présentent généralement des endurances limitées. D'autres types de mémoires résistives, tels que les RRAM (Resistive Random Access Memory), présentent également une endurance limitée.

Il existe donc un besoin pour une mémoires non-volatile à résistance variable montrant une bonne endurance et un rapport on/off élevé, même avec une faible tension de lecture.

Le document [VAROTTO, Sara, NESSI, Luca, CECCHI, Stefano, et al. « Room-temperature ferroelectric switching of spin-to-charge conversion in germanium telluride ». Nature Electronics, 2021, vol. 4, no 10, p. 740-747.] divulgue une mémoire ferroélectrique. Cette mémoire comprend d'une part, une couche ferroélectrique semiconductrice en GeTe, et d'autre part, une électrode conductrice en Ti. En plus de présenter une polarisation ferroélectrique stable, la couche GeTe est également intrinsèquement dégénérée et présente une bande d'énergie interdite faible, de l'ordre de 0,7 eV. Le contact entre l'électrode et la couche ferroélectrique semiconductrice permet de former une barrière Schottky dont la hauteur et/ou la largeur varie en fonction de la polarisation de la couche en GeTe.

**RÉSUMÉ DE L'INVENTION**

L'invention concerne une mémoire comprenant :

- une électrode conductrice principale formant une cathode ;

- une électrode conductrice secondaire formant une anode ; et

- une couche ferroélectrique semiconductrice formant une couche active, disposée entre la cathode et l'anode, la couche active présentant une polarisation ferroélectrique (111) présentant une pluralité d'états stables,

la cathode formant un contact principal avec la couche active, la résistance du contact principal variant de façon strictement monotone en fonction de la polarisation ferroélectrique, le comportement du contact principal formant, en fonction de la polarisation ferroélectrique :

- un contact ohmique pour un premier état stable de la pluralité d'états stables ; et
- un contact Schottky pour au moins un deuxième état stable de la pluralité d'états stables,

la couche active étant dégénérée et présentant une bande d'énergie interdite inférieure à 1,5 eV.

La couche ferroélectrique semiconductrice permet de stocker une information de manière non-volatile grâce à la polarisation ferroélectrique qui peut adopter des états stables. Une mesure de la résistance du contact principal (par exemple en mesurant la résistance totale entre la cathode et l'anode) permet de déterminer dans quel état stable se trouve la polarisation ferroélectrique et dès lors, permet de lire l'information stockée dans la mémoire.

Le changement de comportement (d'ohmique à Schottky ou inversement) pour le contact principal permet de garantir que la variation de résistance associée à deux états distincts est suffisamment grande pour être facilement mesurable.

La couche ferroélectrique semi-conductrice étant dégénérée et avec une bande interdite faible, elle présente une résistivité faible. La résistance mesurable de la mémoire dépend donc principalement de la résistance du contact principal. Dès lors, le rapport ON/OFF, défini comme $\frac{R_{OFF}}{R_{ON}}$, mesuré pour deux états de la polarisation ferroélectrique, **où** $R_{ON}$ est la résistance minimale et $R_{OFF}$ est la résistance maximale, est optimal, par exemple supérieur à $10^7$ voire supérieure à $10^5$.

Grâce au contact principal, la mémoire peut fonctionner comme une diode Schottky. L'électrode conductrice principale forme par exemple une cathode de la diode Schottky tandis que l'électrode conductrice secondaire forme une anode de la diode Schottky. La mémoire principale peut donc être employé dans un circuit où une diode Schottky est utile. Elle peut être employée en tant que sélecteur d'une mémoire La mémoire selon l'invention est doublement avantageuse dans ce genre de circuit car le contact principal peut être rendu ohmique, permettant de « désactiver » la diode Schottky équivalente en la rendant transparente.

Avantageusement, le contact principal forme également un contact Schottky pour un troisième état stable de la pluralité d'états stables, la résistance du contact principal pour le deuxième état stable étant inférieure à la résistance du contact principale pour le troisième état stable.

Ainsi, la mémoire selon l'invention peut conserver un comportement Schottky dont la résistance au niveau de la cathode varie en fonction de l'état dans lequel se trouve la polarisation de la couche ferroélectrique semiconductrice. Les courant de fuites d'une matrice intégrant des mémoires selon l'invention sont ainsi très faibles lorsque la mémoire sélectionnée est électriquement polarisée en direct, ce qui fait que les courants de fuite correspondent à des chemins passant par des mémoires polarisées en inverse et sont donc bloqués.

À la différence de mémoires pour lesquelles un changement de phase, ou un claquage, est réalisé dans une des couches, la mémoire selon l'invention stocke une information grâce à sa polarisation électrique. La polarisation électrique peut être commutée un grand nombre de fois sans induire un vieillissement prononcé. Dès lors, et comme toutes les mémoires ferroélectriques, la mémoire selon l'invention présente une endurance très élevée.

Outre les caractéristiques qui viennent d'être évoquées dans les paragraphes précédents, la mémoire selon l'invention peut présenter une ou plusieurs caractéristiques complémentaires parmi les suivantes, considérées individuellement ou selon toutes les combinaisons techniquement possibles :

Le contact principal forme également un contact Schottky pour un troisième état stable de la pluralité d'états stables, la résistance du contact principal pour le deuxième état stable étant inférieure à la résistance du contact principal pour le troisième état stable.

Le contact principal est formé au niveau d'une interface entre la couche active et la cathode, et dans laquelle, pour chaque état stable, la polarisation ferroélectrique présente, au niveau de ladite interface, une composante normale à ladite interface.

L'anode forme un contact ohmique avec la couche active, la résistance du contact ohmique étant indépendante de la polarisation ferroélectrique.

L'anode est semiconductrice et forme une hétérojonction ou une homojonction avec la couche active. Dans ce cas, l'anode peut comprendre un empilement de deux sous-couches semiconductrices, une première sous-couche semiconductrice étant non-dopée et une deuxième sous-couche semiconductrice étant dopée, la deuxième sous-couche semiconductrice formant une homojonction avec la couche active.

L'anode forme un contact secondaire avec la couche active, la résistance du contact secondaire variant de façon strictement monotone en fonction de la polarisation ferroélectrique, la résistance du contact principal en fonction de la polarisation ferroélectrique présentant une première tendance de monotonie et la résistance du contact secondaire en fonction de la polarisation ferroélectrique présentant une deuxième tendance de monotonie, les deux tendances de monotonie étant opposées.

L'empilement comprend une couche isolante disposée entre la couche ferroélectrique active et la cathode ou entre la couche active et l'anode.

Selon un mode de réalisation avantageux, la couche ferroélectrique active est en GeTe. Dans ce cas, la couche ferroélectrique active en GeTe peut être codopée au Bi et Cu, codopée au Pb et Bi ou dopée au Sn, Cu ou Sb. Selon ce mode de réalisation, le matériau de la cathode est par exemple choisi parmi l'un des matériaux suivants : Pt, Pd, Au, Fe. Le matériau de l'anode peut être choisi parmi l'un des matériaux suivants : Ti, TiN, Ag.

Le matériau de l'anode est un matériau semiconducteur de sorte à former une jonction avec la couche active telle qu'une hétérojonction ou une homojonction. La jonction peut être une homojonction formant une jonction de type PN.

La cathode est réalisée à partir d'un matériau choisi parmi : les métaux de transition ou alliages de métaux de transitions, les métaux de post-transition ou alliages de métaux de post-transition, les matériaux des colonnes I et II du tableau périodique ou les alliages de ces matériaux.

La couche active est cylindrique et est enroulée autour de la cathode ou autour de l'anode.

L'invention concerne en outre un procédé de lecture d'une mémoire selon l'invention, dans lequel le contact Schottky est polarisé en inverse. La tension de lecture appliquée en inverse sur le contact principal est avantageusement strictement inférieure à 0,1 V.

L'invention concerne également un procédé de fabrication d'une mémoire selon l'invention, comprenant :

- minimiser une densité volumique d'énergie U :

$$U = \alpha\rho \left(\frac{I_r}{S}\right)^2 \tau_r + (1 - \alpha)\frac{E_w^2}{\rho}\tau_w$$

avec une résistivité $\rho$, , un rapport lecture/écriture $\alpha$, une tension d'écriture $E_w$, un courant de lecture $I_r$, un temps d'écriture $\tau_w$, et un temps de lecture $\tau_r$ et une surface S, de sorte à obtenir une résistivité optimale; et

- former une cathode, une anode et une couche active de sorte que la couche active soit disposée entre la cathode et l'anode et de sorte que la couche active présente une polarisation ferroélectrique présentant une pluralité d'états stables, et de sorte que la cathode forme un contact principal de surface S optimale avec la couche active, la résistance du contact principal variant de façon strictement monotone en fonction de la polarisation ferroélectrique, le comportement du contact principal formant, en fonction de la polarisation ferroélectrique : un contact ohmique pour un premier état stable de la pluralité d'états stables ; et un contact Schottky pour au moins un deuxième état stable de la pluralité d'états stables, la couche active étant dégénérée et présentant une bande d'énergie interdite inférieure à 1,5 eV.

L'invention concerne aussi porte logique comprenant une première mémoire selon l'invention et une deuxième mémoire selon l'invention, la première mémoire et la deuxième mémoire étant connectées en série ou en parallèle.

L'invention concernant enfin une matrice mémoire comprenant :

- une pluralité de mémoires selon l'invention ;

- une pluralité de lignes conductrices ; et

- une pluralité de colonnes conductrices,

pour chaque mémoire, la cathode est formée par l'une des lignes conductrices et l'anode est formée par l'une des colonnes conductrices.

Dans la matrice selon l'invention, les lignes conductrices peuvent être parallèles les unes par rapport aux autres, les colonnes conductrices peuvent être parallèles les unes par rapport aux autres, les lignes conductrices et les colonnes conductrices étant agencées pour se croiser, chaque mémoire étant disposée à une intersection entre l'une des lignes conductrices et l'une des colonnes conductrices.

L'invention et ses différentes applications seront mieux comprises à la lecture de la description qui suit et à l'examen des figures qui l'accompagnent.

## BRÈVE DESCRIPTION DES FIGURES

Les figures sont présentées à titre indicatif et nullement limitatif de l'invention. Sauf précision contraire, un même élément apparaissant sur des figures différentes présente une référence unique.

Les [Fig. 1] et [Fig. 2] montrent deux modes de réalisation d'une mémoire selon l'invention.

La [Fig. 3] montre trois modes de réalisation supplémentaire d'une mémoire selon l'invention.

La [Fig. 4] montre trois exemples de caractéristique courant-tension pour mesurables pour une mémoire selon l'invention et pour deux mémoires selon l'art antérieur.

Les [Fig. 5], [Fig. 6], [Fig. 7], [Fig. 8], [Fig. 9], [Fig. 10] montrent cinq modes de réalisation d'une matrice selon l'invention.

Les [Fig. 11] et [Fig. 12] montrent deux modes de réalisation d'une porte logique selon l'invention.

## DESCRIPTION DÉTAILLÉE

L'invention vise à améliorer le stockage d'une information, notamment en offrant une endurance et un rapport on/off élevés.

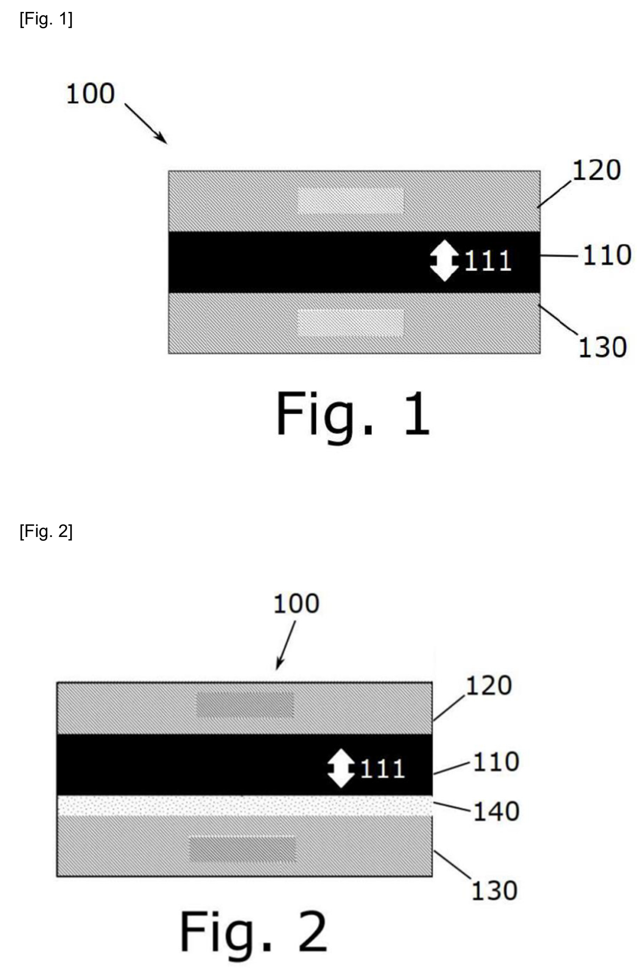

Les figures 1 et 2 montrent deux modes de réalisation d'une mémoire 100 selon l'invention. La mémoire 100 comprend deux électrodes conductrices 120, 130 et une couche ferroélectrique semiconductrice 100.

Les deux électrodes conductrices 120, 130 forment respectivement une électrode principale 120 et une électrode secondaire 130 également appelées respectivement cathode 120 et anode 130. Dans les modes de réalisation des figures 1 et 2, la cathode 120 et l'anode 130 s'étendent parallèlement à un plan et sont superposées l'une par rapport à l'autre.

La couche ferroélectrique semiconductrice 110 forme une couche dite « active ». Elle est destinée à stocker une information. La couche active 110 présente une polarisation ferroélectrique 111. Cette polarisation ferroélectrique 111 correspond par exemple à une moyenne sur un volume des moments dipolaires électrostatiques de la couche active 110.

La polarisation ferroélectrique 111 peut présenter au moins deux états stables distincts. Chaque état stable correspond par exemple à une orientation particulière de la polarisation ferroélectrique 111 et/ou une amplitude particulière de la polarisation ferroélectrique 111. D'un point de vue microscopique, les états stables correspondent par exemple à des configurations particulières des moments dipolaires formant la polarisation ferroélectrique 111. Lorsque la polarisation ferroélectrique 111 présente strictement deux états stables, elle permet de stocker une information binaire. Lorsqu'elle présente strictement plus de deux états stables, par exemple 3 états ou plus, elle permet de stocker une information multivaluée (c'est-à-dire pouvant prendre plus de deux états). Dans un cas extrême, lorsque la polarisation ferroélectrique 111 présente un grand nombre d'états stables, elle permet de stocker une information analogique, c'est-à-dire pouvant prendre une valeur dans une gamme de valeurs. Il s'agit par exemple d'un nombre entre zéro et un ou d'une température normalisée.

Selon l'invention, la cathode 120 forme un premier contact . Ce premier contact est appelé « contact principal ». Le contact peut être formé par une mise en contact direct de la cathode 120 avec la couche active 110. Ce type de contact correspondant à une déformation particulière des bandes d'énergie de la couche active 110 (voire de la cathode lorsque celle-ci est semi-conductrice) pouvant former, à l'interface entre ces deux matériaux, une barrière d'énergie. L'absence de barrière à l'interface (ou alors une barrière négligeable) forme un contact transparent (ou quasi-transparent) également appelé « contact ohmique » ou un contact de résistance non-négligeable appelé « contact Schottky ». On distingue un contact ohmique d'un contact Schottky en ce que le contact ohmique présente une caractéristique I-V linéaire tandis que le contact Schottky présente une caractéristique I-V exponentielle.

La résistance à l'interface entre la couche active 110 et la cathode 120 (que l'on nommera résistance du contact principal) dépend de la présence ou non de la barrière d'énergie à cette interface et de la hauteur et/ou la largeur de cette barrière d'énergie. Dans le cas de l'invention, la résistance du contact principal est particulière en ce qu'elle est fonction de la polarisation ferroélectrique 111. En effet, les bandes d'énergie dans la couche active 110 et la cathode 120 sont influencées par le champ électrique, tel que celui émanant de la polarisation ferroélectrique. Ainsi, à différents états de la polarisation 111 (c'est-à-dire différentes orientation ou amplitude du champ électrique associé) correspondent différents champs appliqués sur le contact principal qui :

-   effacent totalement la barrière d'énergie (on obtient ainsi un contact ohmique) ; ou

-   modulent la hauteur et/ou la largeur de la barrière d'énergie (on obtient ainsi un contact Schottky présentant, pour différentes polarisations, différentes résistances).

L'invention prévoit que la résistance du contact principal est une fonction strictement monotone de la polarisation ferroélectrique 111. Par « strictement monotone », on entend qu'elle présente une dérivée en fonction de la polarisation ferroélectrique 111 qui est strictement positive ou strictement négative. Autrement dit, la résistance ne présente pas deux valeurs égales pour deux états de polarisation distincts. En pratique, la monotonie de la résistance peut être obtenue grâce à la composante hors plan de la polarisation ferroélectrique 111. Par « hors plan », on entend transverse à l'interface formée entre la couche active 110 et la cathode 120. Cette composante hors plan peut être non-nulle. Afin d'assurer la présence d'une composante hors plan, les cathode 120 et anode 130 sont agencées de manière à être alignées avec un axe de polarisation principal de la couche active 110.

Ainsi, une mesure de la résistance du contact principal permet de déterminer une projection de l'état (c'est-à-dire l'orientation et/ou l'amplitude) dans lequel se trouve la polarisation ferroélectrique 111. Autrement dit, une mesure de la résistance de contact principal permet de lire l'information stockée dans la mémoire 100. Dans un mode de réalisation, la polarisation ferroélectrique 111 peut prendre au moins deux états dont :

-   un premier état correspond à une barrière Schottky mesurable (c'est-à-dire présentant une résistance significative par rapport à la résistance de la couche active 110) ; et

-   un deuxième état correspond à une barrière Schottky effacée correspondant à un contact ohmique (autrement un contact transparent, c'est-à-dire dont la résistance n'est pas significative par rapport à la résistance de la couche active 110).

Par « résistance significative », on entend une résistance au moins dix fois supérieure à la résistance de référence (ici, la résistance de la couche active 110). Ainsi, une commutation de la polarisation 111 entre ces deux états permet au contact entre la cathode 120 et la couche active 110 de changer de nature, passant de contact Schottky à contact ohmique, ou inversement.

Le stockage d'une information grâce à la polarisation ferroélectrique 111 et en particulier la commutation d'un état à un autre ne requiert pas de changement structurel de la couche active 110. Par exemple, il n'est pas nécessaire de modifier l'arrangement cristallin de la couche active pour passer par exemple de cristallin à amorphe. Il n'est pas non plus nécessaire de former un filament conducteur au sein de cette couche active 110, par exemple par claquage électrostatique. Ainsi, les mécanismes menant à un vieillissement prématuré de la couche active 110, pour un grand nombre de cycles, sont absents. La mémoire 100 selon l'invention offre donc une bonne endurance.

À deux états de la polarisation ferroélectrique 111 correspondent par exemple deux résistances distinctes (du fait de la monotonie stricte de la résistance). La résistance la plus faible est notée $R_{ON}$ et la résistance la plus élevée est notée $R_{OFF}$. Dans un cas extrême, lorsque le contact est ohmique, alors la résistance $R_{ON}$

est nulle ou presque nulle. La mémoire 100 est alors dite « passante ». Dans un autre cas extrême, la barrière Schottky est renforcée par l'influence de la polarisation ferroélectrique 11. La résistance $R_{OFF}$ est alors maximale. La mémoire 100 est alors dite « bloquée ».

Le « rapport ON/OFF » correspond alors à

$$\alpha = \frac{R_{OFF}}{R_{ON}}$$

Ainsi, plus la résistance $R_{ON}$ est faible et plus le rapport ON/OFF est élevé.

La mesure du rapport ON/OFF ne peut pas s'effectuer qu'au niveau du contact principal. Cette mesure est par exemple réalisée en mesurant la résistance totale entre la cathode et l'anode. Cette mesure prend donc en compte la résistance de la couche active 110. Ainsi, le rapport ON/OFF total devient

$$\alpha = \frac{R_{OFF} \mp R_{110}}{R_{ON} + R_{110}}$$

où $R_{110}$ est la résistance totale de la couche active 110.

Afin de réduire cette résistance au maximum de sorte qu'elle soit négligeable au regard des autres quantités, l'invention prévoit que la couche active 110 est dégénérée et présente une bande d'énergie interdite (dite « band gap » ou « gap » en anglais) faible, en l'occurrence inférieure à 1,5 eV. De cette manière la couche active 110 est conductrice, bien qu'elle soit semiconductrice. Elle présente alors une résistance $R_{110}$ faible, maximisant le rapport on/off total de la mémoire 100.

Dans un mode de réalisation, la couche active 110 est en alliage de GeTe, qui est un semiconducteur ferroélectrique présentant un gap de 0.7 eV et qui est intrinsèquement dégénéré. La faible résistance de la couche active 110 permet par exemple d'atteindre un rapport on/off supérieur à $10^4$. Le matériau $In_2Se_3$ est également un matériau semiconducteur ferroélectrique à faible gap (il présente un gap de 1.35 eV). En revanche il n'est pas intrinsèquement dégénéré. Toutefois, dès lors qu'il est choisi de manière à être dégénéré, il constitue un bon candidat pour former la couche active 110.

La couche active 110 peut être dopée ou codopée pour optimiser la consommation d'énergie lors de la lecture ou de l'écriture de l'information en son sein ou encore améliorer ses propriétés ferroélectriques. Par « codopé », on entend dopé au moyen de deux matériaux dopants différents. Par exemple, elle peut être dopée au Sn, Cu ou Sb. Elle peut être codopée au Bi et Cu ou codopée au Pb et Bi. La couche active 110 est par exemple formée à partir d'un alliage $Ge_xTe_{1-x}$ (où $0 < x < 1$), par exemple en GeTe, dopé ou non, avec les éléments précités.

La couche active 110 peut présenter une épaisseur comprise entre 1 nm et 1 µm. Elle peut présenter des dimensions latérales par exemple une largeur et une longueur ou un diamètre compris entre 1 nm et 10 nm.

Dans certains cas, la barrière Schottky formée à l'interface entre la couche active 110 et la cathode 120 peut complètement s'estomper pour un état de la polarisation ferroélectrique 111 ou alors être renforcée pour un autre état de la polarisation ferroélectrique 111. Ainsi, pour deux états de polarisation 111, la nature du contact principal entre la couche active 110 et la cathode 120 passe de barrière Schottky à ohmique. Le travail de sortie $\phi_{120}$ de la cathode 120 est avantageusement choisi de sorte que le contact entre la couche active 110 et la cathode 120 change de nature pour deux états de polarisation 111.

La nature du matériau formant la cathode 120 est d'une grande importance car il permet de former ou non un contact Schottky. En effet, le travail de sortie $\phi_{120}$ de la cathode 120 doit être choisi en fonction de l'affinité électronique $\chi_{110}$ et du gap $\Delta_{110}$ de la couche active 110. En particulier, le travail de sortie $\phi_{120}$ doit être choisi suivant :

$$\chi_{110} < \phi_{120} < \chi_{110} + \Delta_{110}$$

Dans un mode de réalisation, compatible avec les exemples décrits ci-dessous, la cathode 120 peut être métallique. Elle peut également être formée par un semiconducteur dégénéré ou non. Dans le cas où elle est métallique, elle est par exemple formée par à partir de métaux de transition, ou à partir de métaux de posttransition ou à partir de matériaux des colonnes I et II du tableau périodique ou encore à partir d'un alliage de ces métaux ou matériaux. La cathode 120 est par exemple réalisée à part de Li, Be, Mg, Ca, Sr, Ba, Ra, Ti, Zr, Hf, Rf, V, Nb, Ta, Db, Cr, Mo, W, Sg, Mn, Tc, Re, Bh, Fe, Ru, Os, Hs, Co, Rh, Ir, Ni, Pd, Pt, Cu, Ag, Au, Zn, Cd, Hg, Al, Ga, In, Sn, Bi ou At. De manière préférée, la cathode 120 est formée à partir de Au, Pt, Pd ou Fe.

Dans un mode de réalisation, compatible avec les modes de réalisation décrits ci-dessus, l'anode 130 forme un contact ohmique avec la couche active 110. Ainsi, sa résistance ne varie pas en fonction de la polarisation ferroélectrique 111 de la couche active 110 et elle n'influence pas le rapport on/off. Le choix du matériau formant l'anode 130 permet de s'assurer d'un contact ohmique avec la couche active 110. Le travail de sortie $\phi_{130}$ de l'anode 130 doit être choisi en fonction de l'affinité électronique $\chi_{110}$ et du gap $\Delta_{110}$ de la couche active 110. Le travail de sortie $\phi_{130}$ doit être choisi de sorte que :

$$\phi_{130} < \chi_{110}$$

ou

$$\phi_{130} > \chi_{110} + \Delta_{110}$$

L'anode 130 peut être formée à partir d'un des matériaux précités, dès lors que les inégalités ci-dessus sont respectées. Autrement dit, l'anode 130 est par exemple formée à partir de métaux de transition, ou à partir de métaux de post-transition ou à partir de matériaux des colonnes I et II du tableau périodique ou encore à partir d'un alliage de ces métaux ou matériaux. L'anode 130 est par exemple réalisée à part de Li, Be, Mg, Ca, Sr, Ba, Ra, Ti, Zr, Hf, Rf, V, Nb, Ta, Db, Cr, Mo, W, Sg, Mn, Tc, Re, Bh, Fe, Ru, Os, Hs, Co, Rh, Ir, Ni, Pd, Pt, Cu, Ag, Au, Zn, Cd, Hg, Al, Ga, In, , Sn, Bi ou At. De manière préférée, l'anode 130 est formée à partir de Ti ou Ag.

Alternativement, l'anode 130 peut être semi-conductrice. Ainsi, elle peut former une jonction avec la couche active 110. Elle forme par exemple une hétérojonction avec la couche active 110, par exemple pour une anode 130 en Si et une couche active 110 en GeTe. L'anode 130 peut également former une homojonction avec la couche active, par exemple lorsque l'anode 130 et la couche active 110 sont en $In_2Se_3$ mais que le dopage au sein de ces couches varie. L'homojonction peut alors former une jonction de type PN. L'élément a une caractéristique de diode pour tous les états de polarisation de la couche active 110.

Dans un mode de réalisation, l'anode 130 est un empilement de deux sous-couches semiconductrices dont une première sous-couche est non-dopée et une deuxième sous-couche est dopée. La jonction (hétérojonction ou homojonction, par exemple PN) est alors formée entre la sous-couche semiconductrice dopée et la couche active 110.

Dans un mode de réalisation alternatif, l'anode 130 forme un contact secondaire avec la couche active 110. Ce contact peut être formé par une mise en contact direct de l'anode 130 avec la couche active 110. De manière similaire au contact principal, la résistance du contact secondaire est préférentiellement fonction strictement monotone de la polarisation ferroélectrique 111. Cette dépendance strictement monotone peut par exemple être obtenue dès lors que la polarisation ferroélectrique 111 présente une composante transverse (c'est-à-dire une composante normale à l'interface entre la couche active 110 et l'anode 130).

La formation du contact Schottky secondaire vise à améliorer le rapport on/off de la mémoire 100. Pour cela, il est préférable que les contacts principal et secondaire contribuent positivement l'un avec l'autre. En effet, la mesure de la résistance totale de la mémoire 100 comprend la somme des résistances des contacts principal et secondaire. Ainsi, il est attendu que pour une polarisation ferroélectrique donnée (par exemple vers le haut sur les figures 1 et 2), les résistances des contacts principal et secondaire soient par exemple maximales. Et pour une autre polarisation ferroélectrique donnée (par exemple vers le bas sur les figures 1 et 2), les résistances des contacts principal et secondaire sont par exemple minimales.

En considérant un cas simple où les variations de résistance des deux contacts Schottky sont les mêmes, pour deux états distincts, le rapport on/off devient :

$$\alpha = \frac{2\,R_{OFF} + R_{110}}{2\,R_{ON} + R_{110}}$$

Ainsi, la résistance du contact principal en fonction de la polarisation ferroélectrique 111 et la résistance du contact secondaire en fonction de la polarisation ferroélectrique 111 présentent deux tendances de monotonie, les deux tendances étant opposées. En d'autres termes, si la dérivée de la résistance du contact principal en fonction de la polarisation est strictement positive, alors la dérivée de la résistance du contact secondaire en fonction de la polarisation est strictement négative. Par exemple, si la résistance du contact principal est strictement croissante en fonction de la polarisation ferroélectrique, la résistance du contact secondaire est strictement décroissante en fonction de la polarisation ferroélectrique.

Le mode de réalisation de la figure 2 diffère du mode de réalisation de la figure 1 en ce que la mémoire comprend une couche isolante 140, ferroélectrique ou non, disposée entre la couche active 110 et l'anode 130. La couche isolante 140 peut être vue comme une résistance d'ajustement ou « tunable resistance » selon la terminologie anglais permettant d'ajuster la résistance minimale de la mémoire 100. L'ajout de cette résistance est sans grande incidence sur la résistance totale lorsque la résistance du contact principal (ou des contacts principal et secondaire) est maximale. Cette couche isolante 140 facilite également l'application d'une tension sur la couche active 110 (dite « tension d'écriture) pour faire commuter la polarisation ferroélectrique 111 d'un état à un autre. La couche isolante 140 peut également permettre de limiter la diffusion d'espèces vers la couche active 110 ou depuis la couche active 110 ou encore moduler le piégeage de charge à l'interface entre la couche active 110 et la couche isolante 140 ou entre la couche isolante et l'anode et/ou la cathode.

La couche isolante est par exemple en $HfO_2$, $Al_2O_3$, SiN, PZT, BFO ou BTO. Elle présente une épaisseur comprise entre 0,1 nm et 10 nm.

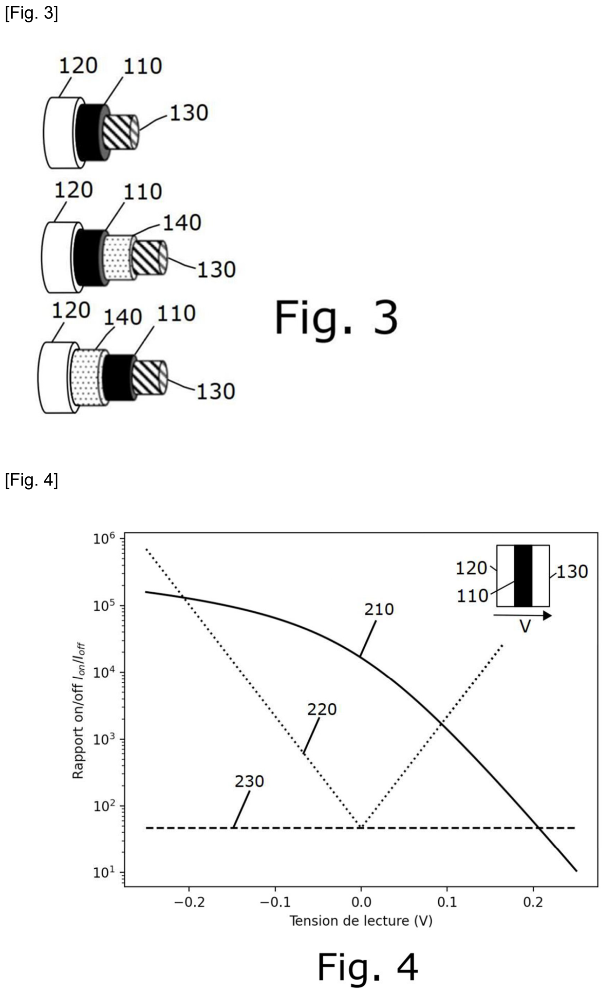

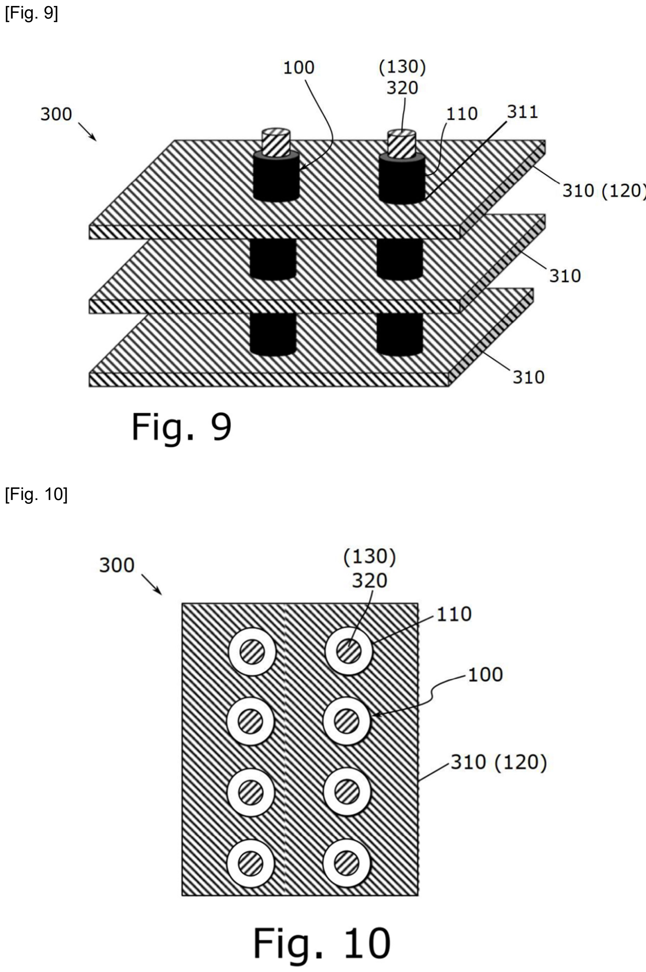

La figure 3 montre partiellement trois modes de réalisation de la mémoire 100 selon l'invention. Dans ces modes de réalisation, la couche active 110 et l'anode 130 sont cylindriques. La couche active 110 est enroulée autour de l'anode 130 comme une gaine autour d'une âme. La cathode 120 peut également être cylindrique et entourer la couche active 110. Alternativement, la couche active 110 pourrait entourer la cathode 120 au lieu d'entourer l'anode 130. Encore alternativement, la cathode 120 est seulement en contact avec une portion, annulaire ou non, de la couche active 110 (voir par exemple le mode de réalisation des figures 9 et 10).

Dans deux des modes illustrés, la mémoire 100 comprend une couche isolante 140 telles que décrit à la figure 2. La couche isolante 140 est également cylindrique est insérée entre la couche active 110 et l'anode 130 ou entre la couche active 110 et la cathode 120.

La figure 4 montre trois courbes 210, 220, 230 correspondants au rapport on/off mesurées en fonction d'une tension appliquée dite « tension de lecture ». La première courbe on/off 210, en trait plein, est un exemple de rapport on/off mesurable aux bornes d'une mémoire 100 selon l'invention. Les deux autres courbes 220, 230, en traits discontinus, sont mesurables aux bornes de mémoires selon l'art antérieur. Un insert montre le sens d'application de la tension de lecture V sur la mémoire (100). Lorsque la tension de lecture V appliquée est positive, la mémoire 100 est polarisée en directe (« forward bias » en anglais), c'est-à-dire que la tension est plus élevée sur l'anode 130 que sur la cathode 120. Lorsque la tension de lecture appliquée est négative, la mémoire 100 est polarisé en inverse (« reverse bias » en anglais), c'est-à-dire que la tension est plus élevée sur la cathode 120 que l'anode 130.

La deuxième courbe on/off 220 correspond à une mémoire symétrique. C'est-à-dire une mémoire présentant deux contacts, respectivement entre la cathode et la couche active 110 et entre l'anode 130 et la couche active 110, pouvant commuter de Schottky à ohmique et inversement, selon l'état de la polarisation ferroélectrique. Si la deuxième caractéristique 220 montre un fort rapport on/off pour une tension de lecture élevée, elle est en revanche minimale autour de 0 V. Le rapport on/off est donc faible pour de faibles tensions de lecture.

La troisième courbe 230 correspond à une mémoire dont le contact entre la cathode 120 et la couche active 110 est un contact de type Schottky dont la résistance varie en fonction de l'état de polarisation ferroélectrique. Dans cette mémoire, le contact entre l'anode 130 et la couche active 110 est ohmique et ne varie pas en fonction de la polarisation ferroélectrique. Le rapport on/off reste constant, quel que soit la tension de lecture appliquée. En revanche, le rapport on/off reste faible, même pour des tensions de lectures élevées.

La première caractéristique 210 correspond à une mémoire dont le contact entre la cathode et la couche active est de type Schottky dans l'état off et de type ohmique à l'état on. La différence de type de contact entre les deux états induits une variation asymétrique. En particulier, elle montre un meilleur rapport on/off lorsqu'elle est polarisée en inverse. De plus, le rapport on/off n'est pas réduit autour de 0 V. Ainsi, la mémoire selon l'invention montre un rapport on/off élevée même pour des tensions de lecture faibles. Ceci est d'autant plus vrai lorsque la mémoire est polarisée en inverse. Par exemple, le rapport on/off est proche de $10^5$ à -0,1 V.

Ainsi, une lecture d'une mémoire 100 selon l'invention peut être réalisée en appliquant une tension, dite « tension de lecture » sur la mémoire de manière à polariser la mémoire 100 en inverse (c'est-à-dire avec une tension plus grande sur la cathode que l'anode). Puisque la conductivité de la couche active 110 est élevée, et qu'elle dépend peu, voire pas, de la polarisation ferroélectrique 111. Ainsi, l'application de la tension de lecture sur la mémoire 100 revient à appliquer ladite tension de lecture sur le contact principal. C'est donc le contact qui est polarisé en inverse.

Afin de réduire la consommation électrique de la mémoire 100, tout en offrant un rapport on/off élevé, la tension de lecture de la mémoire 100 est préférentiellement inférieure à 0,1 V et préférentiellement inférieure à 0,01 V.

Les courbes on/off de la figure 4 ont été obtenues par simulation de trois mémoires telles que décrites. Les paramètres considérés comprennent un travail de sortie de la cathode $\phi_{120} = 0,5$ eV ; un travail de sortie de la couche active $\phi_{110} = 0,4$ eV ; une surface de contact entre la cathode et la couche active S = 2,5 $\mu m^2$ ; une résistance pour la couche active 110 de R = 100 $\Omega$ ; et une température T = 300 K.

Les mécanismes de conduction des électrons à travers la barrière Schottky comprennent notamment l'émission de champ, l'émission Schottky et l'émission thermo-ionique. Dans ce dernier cas, la constante de Richardson effective considérée est A = 200 A cm$^{-2}$ K$^{-2}$,

Lors de la fabrication d'une mémoire 100 selon l'invention, la formation de la cathode 120 sur la couche active 110 peut être réalisée par les techniques de nanofabrication issues de la technologie dite « CMOS » pour « Complementary Metal Oxide Semiconductor » en anglais. La cathode 120 est par exemple lithographiée ou gravée ou déposée par évaporation ou pulvérisation cathodique.

Les propriétés physiques ou géométriques de la mémoire 100 peuvent être adaptées pour répondre à des contraintes opératoires précises. Par exemple, une résistivité maximum de la couche active 100 (et donc de la mémoire 100 à l'état bas) peut être demandée. Pour cela, la fabrication de la mémoire 100 peut prévoir une étape d'optimisation visant à adapter les propriétés physiques ou géométriques de la mémoires 100.

Par exemple, minimiser l'équation suivante :

$$U = \alpha \rho \left(\frac{I_r}{S}\right)^2 \tau_r + (1 - \alpha) \frac{E_w^2}{\rho} \tau_w$$

avec une résistivité ciblée $\rho$, une densité volumique d'énergie $U$, une proportion de lecture/écriture (alpha caractérise le profil d'utilisation de la mémoire), une tension d'écriture $E_w$, un courant de lecture $I_r$, un temps d'écriture $\tau_w$, et un temps de lecture $\tau_r$ et une surface S entre la cathode 120 et la couche active 110, peut permettre d'obtenir une résistivité optimale.

En supposant que l'influence du dopage sur la tension d'écriture $E_w$ et sur le courant de lecture $I_r$ est négligeable, la résistivité ciblée optimale est :

$$\rho = \frac{E_w S}{I_r} \sqrt{\frac{\tau_w (1 - \alpha)}{\tau_r \alpha}}$$

La résistivité ciblée $\rho$ peut également être choisie pour être minimale afin de maximiser le rapport on/off. En effet, la résistance dans l'état de haute résistance étant dominée par le contact Schottky et l'état de basse résistance étant ohmique, la minimisation de la résistivité $\rho$ va réduire la résistance totale de l'état de basse résistance sans affecter la résistance de l'état de haute résistance. Le rapport on/off est donc amélioré.

Une mémoire 100 selon l'invention peut être mise en œuvre pour une application de stockage, ou pour des calculs booléens, notamment dans le cadre de calculs dans la mémoire (dit « in-memory computing » en anglais), ou encore pour l'intelligence artificielle, par exemple en tant que synapse d'un réseau de neurones artificiels.

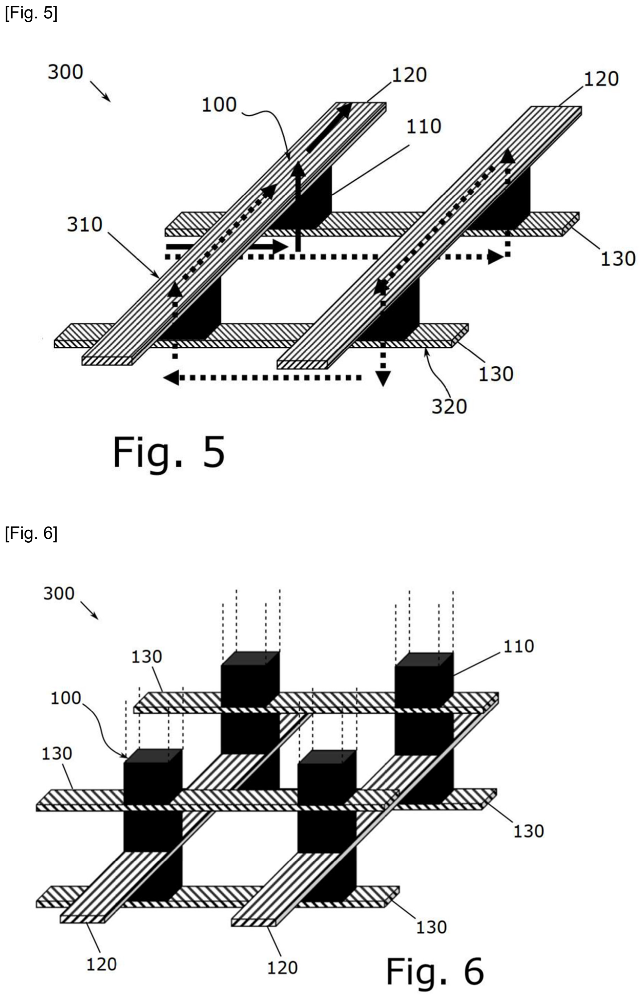

À cette fin, les figures 5 à 10 montrent différents modes de réalisation d'une matrice mémoire 300 selon l'invention, permettant de réaliser du stockage d'information ainsi que mettre les mémoires en relations pour réaliser des calculs logiques dans les mémoires 100.

La matrice 300 comprend notamment une pluralité de mémoires 100 et une architecture de connexion permettant d'adresser indépendamment chaque mémoire 100. Dans les exemples illustrés, l'architecture de connexion est de type « crossbar ». Une architecture crossbar comprend une pluralité de lignes conductrices 310 et une pluralité de colonnes conductrices 320, s'entrecroisant. Ces lignes et colonnes 310, 320 prennent par exemple la forme de pistes métalliques. Chaque mémoire 100 est connectée à l'une des lignes conductrices 310 et l'une des colonnes conductrices 320 et est préférentiellement disposée à l'intersection entre ladite ligne conductrice 310 et ladite colonne conductrice 320. De la sorte, l'application d'une tension entre la ligne conductrice 310 et la colonne conductrice 320 permet de polariser la mémoire 100 qui se trouve à l'intersection. Ainsi, chaque mémoire 100 peut être adressée indépendamment des autres mémoires. La connexion des mémoires 100 selon cette architecture forme un arrangement matriciel.

Dans la figure 5, les lignes 310 sont agencées de manière parallèle les unes aux autres. Les colonnes 320 sont également agencées de manière parallèle les unes aux autres. Les lignes 310 sont disposées dans un premier plan et les colonnes 320 sont disposées dans un second plan, distinct du premier plan et parallèle à ce dernier. Les lignes 310 et colonnes 320 se croisent en formant, en projection, un angle droit. Chaque mémoire 100 est disposée à cette intersection, en joignant le premier plan au second plan.

Dans une architecture crossbar, plusieurs mémoires 100 (au moins deux) sont connectées à une même ligne 310 et plusieurs autres mémoires 100 (également au moins deux) sont connectées à une même colonne 320. Ainsi, l'application d'une tension électrique entre une ligne 310 et une colonne 320 peut induire des courants circulant dans les mémoires 100 qui ne sont pas connectées à l'intersection de la ligne et la colonne. Ces courants forment des courants de fuite. La figure 5 montre en traits pleins un courant induit par l'application d'un potentiel entre une ligne 310 et une colonne 320. La figure 5 montre en pointillés un courant de fuite pouvant passer par plusieurs lignes 310, colonnes 320 et mémoires 100.

Grâce aux contacts principal et secondaire entre, respectivement, la cathode 120 et la couche active 110 et l'anode 130 et la couche active, les mémoires 100 connectées peuvent fonctionner comme des diodes Schottky. À la différence de diodes Schottky standard, le niveau de résistance de la diode varie en fonction de sa polarisation ferroélectrique. La connexion de mémoires 100 fonctionnant comme des diodes Schottky permet de réduire drastiquement la circulation de courants de fuites. En effet, les mémoires 100 dont la polarisation ferroélectrique induit un contact Schottky au niveau de leurs deux contacts présentent une forte impédance qu'elles soient dans l'état haut ou bas. Ainsi, elles présentent toujours une impédance élevée.

La matrice 300 peut comprendre des dispositifs monostables ou bistables, normalement bloqués, formant des sélecteurs. Chaque sélecteur est alors connecté en série à l'une des mémoires 100. Les sélecteurs présentent normalement une impédance élevée, bloquant la circulation de courants, sauf dans la mémoire connectée à la ligne et la colonne auxquelles sont appliquées la tension de lecture (ou d'écriture). Même lorsqu'ils sont passant, les sélecteurs peuvent présenter une impédance importante. La forte variation d'impédance des mémoires 100 selon l'invention (qui correspond notamment au rapport on/off des mémoires) rend celle-ci mesurable, même série avec une sélecteur présentant une forte impédance.

La formation d'une hétérojonction ou d'une homojonction (par exemple de type PN) entre la couche active 110 et l'anode 130 (décrit en référence aux figures 1 et 2) permet d'intégrer la fonction de sélecteur à chaque mémoire 100.

Dans un mode de réalisation, les lignes 310 et colonnes 320 de la matrice 300 forment respectivement les cathodes 120 et anodes 130 des mémoires 100 qu'elles connectent. En effet, les matériaux présentés pour réaliser les lignes 310 et colonnes 320 sont tout à fait susceptibles de former les lignes et colonnes d'architecture crossbar. Ainsi, il n'est pas nécessaire de prévoir plusieurs niveaux pour les cathodes et anodes et pour les lignes et colonnes. La matrice 300 présente donc un encombrement réduit.

La figure 6 montre un mode de réalisation de la matrice 300 où, à la différence de la matrice 300 de la figure 5, elle comprend plusieurs pluralités de lignes et de colonnes s'entrecroisant sur plusieurs niveaux de manière à former des empilements de mémoires 300. Ce type d'architecture est dit « crossbar 3D » car il tire également partie d'une troisième dimension de l'espace pour empiler les couches de matrice et réduire l'encombrement latérale de la matrice 300.

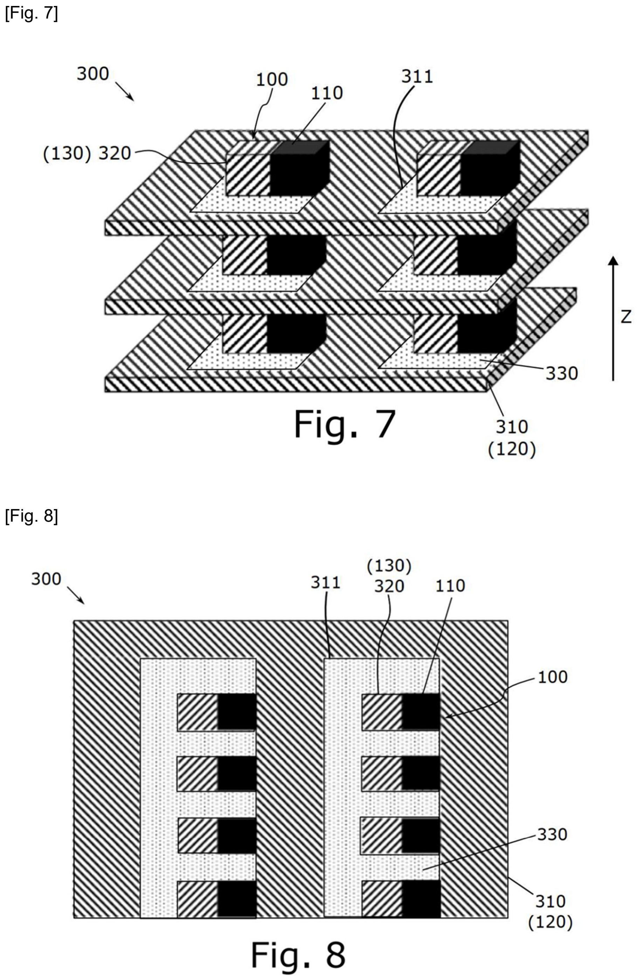

Les figures 7 et 8 montrent deux autres modes de réalisation de la matrice 300 selon une vue en perspective et une vue de dessus. Ces matrices 300 diffèrent de la figure 5 en ce que les colonnes 320 s'étendent verticalement (la verticale étant représentée par l'axe Z) et en ce que les lignes 310 forment des couches ou des plaques, agencées verticalement les unes au-dessus des autres. Des ouvertures 321, pratiquées dans chaque ligne 310, permettent le passage des colonnes 320 à travers les lignes. Pour connecter chaque mémoire 100 à une colonne 320 et une ligne 310, ladite mémoire 100 s'étend par exemple contre une portion au moins de la colonne 320 et contre un bord de l'ouverture 311 pratiquée dans la ligne.

Avantageusement, dans ce mode de réalisation les lignes 310 et colonnes 320 forment également les cathodes 120 et anodes 130 des mémoires 100. De manière encore plus avantageuse, et comme présenté en figure 7, une pluralité de mémoires 100 connectées à la même colonne 320 partagent une même couche active 110. La couche active 110 s'étend contre la colonne 320, sur toute la hauteur de la colonne 320. Chaque mémoire 100 est alors localisée à une intersection entre la colonne 320 et l'une des lignes 310. Afin d'éviter toute perturbation entre les mémoires 100, les lignes 310 sont espacées d'une distance supérieure à une longueur de domaine ferroélectrique de la couche active 100 et préférentiellement supérieure à dix fois la longueur de domaine ferroélectrique de la couche active 100. Par « longueur de domaine ferroélectrique », on entend une dimension caractéristique d'un domaine ferroélectrique (telle que son diamètre). Cette longueur de domaine est par exemple comprise entre quelques nanomètres à quelques dizaines de nanomètres.

Un élément isolant 330 disposé dans l'ouverture 311 de chaque ligne 310 permet d'assurer un soutien mécanique, en permettent de conserver un contact entre le couche active 110 et le bord de chaque ouverture 311. Cet élément isolant 330 permet également d'isoler la colonne 320 et la ligne 310.

Les modes de réalisation des figures 7 et 8 diffèrent de celui de la figure 6 en ce qu'elles permettent d'inclure la possibilité d'un matériau ferroélectrique avec une polarisation ferroélectrique hors plan (pour la figure 6) et dans le plan (pour les figures 7 et 8).On entend par « hors plan » une polarisation selon une direction perpendiculaire au plan du substrat et « dans le plan » une polarisation selon une direction dans le plan du substrat.

Les modes de réalisation des figures 9 et 10 montrent deux autres modes de réalisation de la matrice 300 selon une vue en perspective et une vue de dessus. Ces modes de réalisation correspondent à un matériau ferroélectrique avec une polarisation dans le plan. Ces matrices 300 combinent les modes de réalisation des figures 7 et 8 et de la figure 3. En effet, pour ces matrices également, les lignes 310 et colonnes 320 forment les cathodes 120 et anodes 130 des mémoires 100. Dans ces modes de réalisation, les colonnes 310 sont cylindriques. La couche active 110, commune à une pluralité de mémoires 100, est également cylindrique et entoure la colonne 320. La couche active 110 est en contact avec la totalité de l'ouverture 311 par laquelle passent la colonne 320 et la couche active 110. La ligne 310 est donc en contact avec une portion annulaire de la couche active 110.

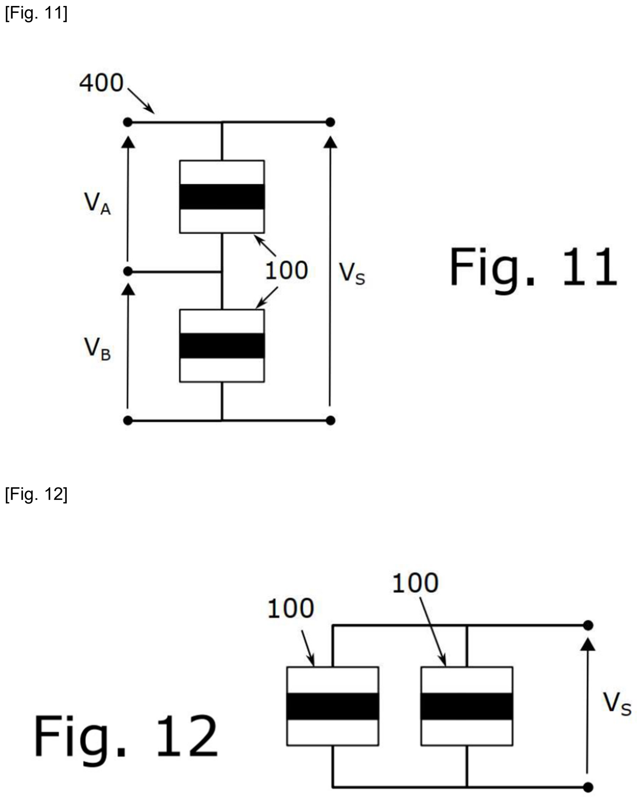

Les figures 11 et 12 montrent deux assemblages de mémoires permettant de réaliser respectivement une porte logique OU et une porte logique ET.

La porte logique OU (figure 11) correspond à la mise en série de deux mémoires. L'impédance totale de cette chaîne de mémoires 100 sera alors à haute impédance si l'une des mémoires 100 est à haute impédance. L'impédance sera à basse impédance si toutes les mémoires 100 sont à basses impédances. En agissant sur la polarisation ferroélectrique de chaque mémoire, il est alors possible de réaliser une opération binaire OU. Connecter au moins de trois mémoires en série permet de réaliser une opération logique OU sur au moins trois entrées.

La porte logique ET (figure 12) correspond à la mise en parallèle de deux mémoires. L'impédance totale de cette chaîne de mémoires 100 sera alors à haute impédance si toutes les mémoires 100 sont à haute impédance. L'impédance totale sera à basse impédance si l'une au moins des mémoires 100 est à basse impédance. Connecter au moins de trois mémoires en parallèle permet de réaliser une opération logique ET sur au moins trois entrées.

## Revendications

1. Mémoire (100) comprenant :

   - une électrode conductrice principale (120) formant une cathode ;
   - une électrode conductrice secondaire (130) formant une anode ; et
   - une couche ferroélectrique semiconductrice (110) formant une couche active, disposée entre la cathode et l'anode (120, 130), la couche active (110) présentant une polarisation ferroélectrique (111) présentant une pluralité d'états stables,

   la cathode (120) formant un contact principal avec la couche active (110), la résistance du contact principal variant de façon strictement monotone en fonction de la polarisation ferroélectrique (111), le comportement du contact principal formant, en fonction de la polarisation ferroélectrique (111) :

- un contact ohmique pour un premier état stable de la pluralité d'états stables ; et
- un contact Schottky pour au moins un deuxième état stable de la pluralité d'états stables,

la couche active (110) étant dégénérée et présentant une bande d'énergie interdite inférieure à 1,5 eV.

2. Mémoire (100) selon la revendication 1, dans laquelle le contact principal forme également un contact Schottky pour un troisième état stable de la pluralité d'états stables, la résistance du contact principal pour le deuxième état stable étant inférieure à la résistance du contact principal pour le troisième état stable.

3. Mémoire (100) selon l'une des revendications 1 ou 2, dans laquelle le contact principal est formé au niveau d'une interface entre la couche active (110) et la cathode (120), et dans laquelle, pour chaque état stable, la polarisation ferroélectrique présente, au niveau de ladite interface, une composante normale à ladite interface.

4. Mémoire (100) selon l'une des revendications 1 à 3, dans laquelle l'anode (130) forme un contact ohmique avec la couche active (110), la résistance du contact ohmique étant indépendante de la polarisation ferroélectrique (111).

5. Mémoire (100) selon l'une des revendications 1 à 3, dans laquelle l'anode (130) forme un contact secondaire avec la couche active (110), la résistance du contact secondaire variant de façon strictement monotone en fonction de la polarisation ferroélectrique (111), la résistance du contact principal en fonction de la polarisation ferroélectrique (111) présentant une première tendance de monotonie et la résistance du contact secondaire en fonction de la polarisation ferroélectrique (111) présentant une deuxième tendance de monotonie, les deux tendances de monotonie étant opposées.

6. Mémoire (100) selon l'une des revendications précédentes, dans laquelle l'empilement comprend une couche isolante (140) disposée entre la couche ferroélectrique active (110) et la cathode (120) ou entre la couche active (110) et l'anode (130).

7. Mémoire (100) selon l'une des revendications précédentes **caractérisé en ce que** la couche ferroélectrique active est en GeTe.

8. Mémoire selon la revendication précédente, dans laquelle la couche ferroélectrique active en GeTe est codopée au Bi et Cu, codopée au Pb et Bi ou dopée au Sn, Cu ou Sb.

9. Mémoire selon l'une des revendications 7 à 8 dans laquelle le matériau de la cathode (120) est choisi parmi l'un des matériaux suivants : Pt, Pd, Au, Fe.

10. Mémoire selon l'une des revendications 7 à 9 dans laquelle le matériau de l'anode (130) est choisi parmi l'un des matériaux suivants : Ti, TiN, Ag.

11. Mémoire selon l'une des revendications 1 à 9 dans laquelle le matériau de l'anode (130) est un matériau semiconducteur de sorte à former une jonction avec la couche active (110) telle qu'une hétérojonction ou une homojonction.

12. Mémoire selon la revendication précédente dans laquelle la jonction est une homojonction formant une jonction de type PN.

13. Mémoire (100) selon l'une des revendications précédentes, dans laquelle la cathode (120) est réalisée à partir d'un matériau choisi parmi : les métaux de transition ou alliages de métaux de transitions, les métaux de post-transition ou alliages de métaux de post-transition, les matériaux des colonnes I et II du tableau périodique ou les alliages de ces matériaux.

14. Mémoire (100) selon l'une des revendications précédentes, dans laquelle la couche active (110) est cylindrique et est enroulée autour de la cathode (120) ou autour de l'anode (130).

15. Lecture d'une mémoire (100) selon l'une des revendications 1 à 14, dans lequel le contact Schottky est polarisé en inverse.

16. Procédé de fabrication d'une mémoire (100) selon l'une des revendications 1 à 14, comprenant :

    - minimiser une densité volumique d'énergie U :

$$ U = \alpha\rho \left(\frac{I_r}{S}\right)^2 \tau_r + (1 - \alpha)\frac{E_w^2}{\rho}\tau_w $$

    avec une résistivité $\rho$, , un rapport lecture/écriture $\alpha$, une tension d'écriture $E_w$, un courant de lecture $I_r$, un temps d'écriture $\tau_w$, et un temps de lecture $\tau_r$ et une surface S, de sorte à obtenir une résistivité optimale; et
    - former une cathode (120), une anode (130) et une couche active (110) de sorte que la couche active (110) soit disposée entre la cathode (120) et l'anode (130) et de sorte que la couche active (110) présente une polarisation ferroélectrique (111) présentant une pluralité d'états stables, et de sorte que la cathode (120) forme un contact principal de surface S optimale avec la couche active (110), la résistance du contact principal variant de façon strictement monotone en fonction de la polarisation ferroélectrique (111), le comportement du contact principal formant, en fonction de la polarisation ferroélectrique (111) : un contact ohmique pour un premier état stable de la pluralité d'états stables ; et un contact Schottky pour au moins un deuxième état stable de la pluralité d'états stables, la couche active (110) étant dégénérée et présentant une bande d'énergie interdite inférieure à 1,5 eV.

17. Matrice (300) mémoire comprenant :

- une pluralité de mémoires (100) selon l'une des revendications 1 à 14 ;
- une pluralité de lignes conductrices (310) ; et
- une pluralité de colonnes conductrices (320),

pour chaque mémoire (100), la cathode (120) est formée par l'une des lignes conductrices (310) et l'anode (130) est formée par l'une des colonnes conductrices (320).

18. Matrice (300) selon la revendication précédente, dans laquelle les lignes conductrices (310) sont parallèles les unes par rapport aux autres, les colonnes conductrices (320) sont parallèles les unes par rapport aux autres, les lignes conductrices et les colonnes conductrices étant agencées pour se croiser, chaque mémoire (100) étant disposée à une intersection entre l'une des lignes conductrices (310) et l'une des colonnes conductrices (320).

[Fig. 1]

Fig. 1

[Fig. 2]

Fig. 2

[Fig. 3]

Fig. 3

[Fig. 4]

Fig. 4

[Fig. 5]

Fig. 5

[Fig. 6]

Fig. 6

[Fig. 7]

Fig. 7

[Fig. 8]

Fig. 8

[Fig. 9]

Fig. 9

[Fig. 10]

Fig. 10

[Fig. 11]

400

$V_A$

100

$V_B$

$V_S$

Fig. 11

[Fig. 12]

100 100

Fig. 12

$V_S$

Europäisches
Patentamt

European
Patent Office

Office européen
des brevets

# RAPPORT DE RECHERCHE EUROPEENNE

**Numéro de la demande**

EP 25 22 6587

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| X | US 2021/358533 A1 (LOH KIAN PING [SG] ET AL) 18 novembre 2021 (2021-11-18) | 1,3-7,9, 11-16 | INV. H10B63/00 |
| Y | * alinéas [0009], [0015], [0071] – [0075]; figures 4a-4c * | 8,10,17, 18 | H10N70/00 H10N70/20 |
| A | | 2 | |
| | ----- | | |
| X,D | SARA VAROTTO ET AL: "Room-temperature ferroelectric switching of spin-to-charge conversion in GeTe", ARXIV.ORG, CORNELL UNIVERSITY LIBRARY, 201 OLIN LIBRARY CORNELL UNIVERSITY ITHACA, NY 14853, 13 mars 2021 (2021-03-13), XP081983077, DOI: 10.1038/S41928-021-00653-2 | 1,6,11, 12 | |
| A | * page 5 - page 7; figure 1 * | 2 | |
| | ----- | | |
| X | KREMPASK\'Y ET AL: "Operando imaging of all-electric spin texture manipulation in ferroelectric and multiferroic Rashba semiconductors", ARXIV.ORG, CORNELL UNIVERSITY LIBRARY, 201 OLIN LIBRARY CORNELL UNIVERSITY ITHACA, NY 14853, 26 juillet 2017 (2017-07-26), XP081278890, DOI: 10.1103/PHYSREVX.8.021067 * page 1 - page 3; figure 1 * | 1 | **DOMAINES TECHNIQUES RECHERCHES (IPC)** H10B H10N |
| | ----- | | |
| Y | WO 2013/040714 A1 (INST NAT RECH SCIENT [CA]) 28 mars 2013 (2013-03-28) * alinéas [0029], [0069] * | 10,17,18 | |
| | ----- | | |
| | -/-- | | |

Le présent rapport a été établi pour toutes les revendications

| Lieu de la recherche | Date d'achèvement de la recherche | Examinateur |
|---|---|---|
| Munich | 5 mai 2026 | Angermeier, Detlef |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

..............................................................................

& : membre de la même famille, document correspondant

EPO FORM 1503 03.82 (P04C02)

page 1 de 2

Europäisches
Patentamt

European
Patent Office

Office européen
des brevets

**RAPPORT DE RECHERCHE EUROPEENNE**

Numéro de la demande

**EP 25 22 6587**

## DOCUMENTS CONSIDERES COMME PERTINENTS

| Catégorie | Citation du document avec indication, en cas de besoin, des parties pertinentes | Revendication concernée | CLASSEMENT DE LA DEMANDE (IPC) |
|---|---|---|---|
| Y | ZHU JIADI ET AL: "A comprehensive review on emerging artificial neuromorphic devices", APPLIED PHYSICS REVIEWS, AMERICAN INSTITUTE OF PHYSICS, 2 HUNTINGTON QUADRANGLE, MELVILLE, NY 11747, vol. 7, no. 1, 24 février 2020 (2020-02-24), XP012244905, DOI: 10.1063/1.5118217 * page 23, colonne 1 * ----- | 8 | |
| | | | **DOMAINES TECHNIQUES RECHERCHES (IPC)** |

Le présent rapport a été établi pour toutes les revendications

| Lieu de la recherche | Date d'achèvement de la recherche | Examinateur |
|---|---|---|
| Munich | 5 mai 2026 | Angermeier, Detlef |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

page 2 de 2

**ANNEXE AU RAPPORT DE RECHERCHE EUROPEENNE
RELATIF A LA DEMANDE DE BREVET EUROPEEN NO.**

EP 25 22 6587

La présente annexe indique les membres de la famille de brevets relatifs aux documents  brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

05-05-2026

| Document brevet cité au rapport de recherche | Date de publication | Membre(s) de la famille de brevet(s) | Date de publication |
|---|---|---|---|
| US 2021358533 A1 | 18-11-2021 | CN 112639975 A | 09-04-2021 |
| | | SG 11202101337S A | 30-03-2021 |
| | | US 2021358533 A1 | 18-11-2021 |
| | | WO 2020050778 A1 | 12-03-2020 |
| WO 2013040714 A1 | 28-03-2013 | AUCUN | |

EPO FORM P0460

Pour tout renseignement concernant cette annexe : voir Journal Officiel de l'Office européen des brevets, No.12/82

# EP 4 770 313 A1

## RÉFÉRENCES CITÉES DANS LA DESCRIPTION

**Littérature non-brevet citée dans la description**

- **VAROTTO** ; **SARA** ; **NESSI** ; **LUCA** ; **CECCHI** ; **STEFANO et al.** Room-temperature ferroelectric switching of spin-to-charge conversion in germanium telluride. *Nature Electronics*, 2021, vol. 4 (10), 740-747